# EUROPEAN PATENT SPECIFICATION

(11) **EP 0 522 600 B1**
(45) Date of publication and mention of the grant of the patent: **06.09.1995**
(21) Application number: 92116062.8
(22) Date of filing: 09.12.1988
(51) Int. Cl.: H01G 2/06

(54) **Chip type capacitor**
Chipkondensator
Condensateur du type puce

(30) Priority: 09.12.1987 JP 311410/87; 24.12.1987 JP 328032/87; 28.12.1987 JP 332923/87; 26.02.1988 JP 43681/88; 15.04.1988 JP 92885/88; 30.04.1988 JP 108414/88; 30.04.1988 JP 108415/88; 15.06.1988 JP 147880/88; 29.06.1988 JP 161430/88; 09.12.1987 JP 311409/87; 09.12.1987 JP 311412/87
(43) Date of publication of application: 13.01.1993
(62) Divisional of application: 88120654.4
(73) Proprietor: NIPPON CHEMI-CON CORPORATION, Oume-shi Tokyo 198 (JP)
(72) Inventor: Hagiwara, Ikuo, c/o Nippon Chemi-Con Corp., Ome-shi, Tokyo 198 (JP); Ando, Susumu, c/o Nippon Chemu-Con Corp., Ome-shi, Tokyo 198 (JP); Fujiwara, Masayuki, c/o Nippon Chemi-Con Corp., Ome-shi, Tokyo 198 (JP); Endo, Keiichi, c/o Nippon Chemi-Con Corp., Ome-shi, Tokyo 198 (JP); Kawahara, Hideki, Nippon Chemi-Con Corp., Ome-shi, Tokyo 198 (JP); Hirano, Makoto, c/o Nippon Chemi-Con Corp., Ome-shi, Tokyo 198 (JP)
(74) Representative: Baronetzky, Klaus, Dipl.-Ing.

(56) References cited:
- EP-A- 0 169 261
- EP-A- 0 192 818
- JP-A-60 245 116

## Description

The invention relates to a chip type capacitor assembly, according to the opening portion of claim 1, which is especially suitable for mounting on the surface of a printed circuit board.

Hitherto, the capacitor chipping has been realized such that a capacitor element is first accommodated in a sheathing case made from synthetic resin for subjecting to a resin mold processing. The terminals of the capacitor used for exterior connection and derived from an end of the resin were bent alongside the end of the resin to match with the wiring pattern of the printed circuit board.

Japanese Utility Model Publication 59-3557 proposes to accommodate the conventional capacitor in a sheathing frame and to arrange the terminals in the same plane as the end of the sheathing frame. Another proposal is disclosed in Japanese patent publication 60-245 116. According to this proposal, a capacitor is arranged on a closed-end cylindrical sheathing frame for derivation of the terminals from a through-hole on the underside of the sheathing frame and to bend the terminals to a concave section provided on the external surface of the sheathing frame.

These conventional chip type capacitors are capable of a surface mounting without changing the ordinary structure of the capacitor.

However, such conventional chip type capacitors with mold processing comprise capacitor elements which are likely to be subjected to a heat deterioration due to a thermal stress during mold processing. Moreover particularly for an electrolytic capacitor, it is necessary to mold an electrolyte in a liquid state together with capacitor elements and since the mold processing requires sophisticated sealing properties, the manufacturing process is likely complex.

With the chip type capacitors in which an ordinary capacitor is accommodated in the sheathing frame, means for suspending a body of the capacitor in the accommodating space provided in the sheathing frame have never been available. Same applies to means to determine the position of the body of the capacitor in the sheathing frame for which reason the position used as a reference for the bending process of the lead wire will be unreliable and generate an unnecessary stress to be applied on the lead wire which may affect capacitor elements badly in the course of processing.

Furthermore, as the case may be, the body of the capacitor easily falls out of the sheathing frame with difficulty in manufacturing a chip type capacitor.

When the capacitor is accommodated in a closed-end cylindrical sheathing frame, fixing and positioning of the body of the capacitor may be available, not withstanding lead wires which must inserted through the through-hole provided on the underside of the sheathing frame with an inconvenient manufacturing process. In other words, according to this process, normally two lead wires derive from the capacitor and must be inserted through the through-hole provided on the underside of the sheathing frame while accomodating the capacitor in the sheathing frame. Accordingly, an adjustment must be made to the directions of the body of the capacitor and the sheathing frame as well as to the position and direction of the lead wires derived from the body of the capacitor, for which reason a high processing accuracy is required resulting in the disadvantage of a sophisticated manufacturing process.

With the chip type capacitor according to Japanese lead open patent publication 60-245 116, it is required to use wires having elastic properties, in order to insert the wires correctly into the small holes provided on the underside of this sheathing frame, and then to bend them as it is required for production of the printed circuit board. On the other hand, these elastic properties make a correct bending to a desired shape difficult as any bending process requires an overbending in order to allow the wires to resiliently return to its pre-formed shape.

Therefore, it is an object of the present invention to provide a chip type capacitor according to the opening portion of claim 1 which is better suitable for mounting on the surface of printed circuit boards incurring an easier and more flexible production process without being affected by the processing accuracy during the manufacturing process.

This object is settled by the features given in claim 1. Advantageous developments may be taken from the subclaims.

The invention allows the manufacturing of a chip type capacitor with wires which have any desired shape and material selection. The wires may be inserted into the sheathing frame from the backside penetrating an aperture formed on the opposite side for leading out the lead wires. It is advantageous that this aperture comprises a wall section which does not hinder the wires to be inserted through the aperture but forms a shoulder for inserting the capacitor. The wall section with its upper edge may be used as a bending aid of the wires which may have been re-shaped by bending 90° outwards right after exiting the capacitor and then 90° back again in order to allow bending at any desired point on the upper end of the wall section.

According to the invention, the wall section is provided with a protuberance of a height which is higher than the external diameter of the lead wires. This protuberance allows a great flexibility both in shaping the wires and in arranging the chip type capacitor assembly on the PCB, also if conductive lines are lead under the capacitor.

Notched slot sections are provided on the underside of the sheathing frame or on the side adjacent thereto to accommodate lead wires which may be lead to the end of the sheathing frame which is opposed to the end of the wall section. Also, a resin layer may be arranged for one side of the aperture of the sheathing frame to cover a lead-out section of the lead wires.

A method of manufacturing a chip type capacitor provides a distance between each lead wire which is rectangularly bent deriving from the end of the capacitor to a desired distance. The capacitor is then accommodated in the sheathing frame before bending the lead wires alongside from an end of the aperture of the sheathing frame to the underside thereof. This distance may be provided beforehand larger than the overall size of the external shape of the capacitor, and also lead wires may be bent in the vicinity of a lead-out section of lead wires derived from an end of the aperture of the sheathing frame and then tacked below the dimension of the internal diameter of the accommodating space of the sheathing frame. The capacitor is accommodated into the sheathing frame before lead wires are bent at the lead-out section for restoration to the original dimensions.

After having the capacitor accommodated in the sheathing frame, a resin layer may be provided in one side of the aperture of the sheathing frame from which the lead wires are derived. This resin layer is intended to cover at least a lead-out section of the lead wires from the capacitor sealing body before the lead wires are bent alongside from the end of the aperture of the sheathing frame to the underside thereof. By this resin layer the lead wires are stabilized at the first and second bend thereof, avoiding the likelihood of breakage due to stress.

The inventive capacitor may be utilized both in a flat and in a standing position to be mounted on the printed circuit board. In both cases, the distance between the lead wires is exactly predefined, due to the rectangular shaping of the wires right after leaving the capacitor sealing body.

With the sheathing frame having one aperture at one end and another aperture at the other end, the capacitor may be inserted into the accommodating space easily, with the lead wires protruding to the common other aperture. As the wall section is provided on one aperture, the position of the capacitor accommodated in the sheathing frame is conveniently determined. It is not necessary to carry out a special positioning step or the like of the capacitor in the accommodating space during the bending process of the lead wires, and the body of the capacitor does not fall off during the manufacturing process or from the completed chip type capacitor. The bending process of the lead wires may be conveniently performed permitting the lead wires of the capacitor to provide a distance compatible with the distance of the wiring pattern of the printed circuit boards.

Preferred embodiments of the chip type capacitor according to the invention are described in detail with reference to the accompanying drawings which show in:
- Fig. 1: a perspective view of an embodiment of a chip-type capacitor according to the invention;
- Fig.2: a perspective view of an example of change in shape of the chip type capacitor as shown in Fig. 1;
- Fig. 3: a perspective view showing another embodiment of the chip type capacitor according to the invention;
- Fig. 4: a perspective view of an example of change in shape of the chip type capacitor as shown in Fig. 3;
- Fig. 5 (a), (b) and (c): pictorial views of the manufacturing process descriptive of embodiments of the chip type capacitor according to the invention;
- Fig. 6: a front elevation showing an example of change in shape of the sheathing frame used in the manufacturing method of the chip type capacitor as shown in Fig. 5;
- Fig. 7: a perspective view showing examples of providing a resin layer for sealing the aperture; and
- Fig. 8 (a), (b) and (c): pictorial views of the manufacturing process descriptive of the embodiment as shown in Fig. 7.

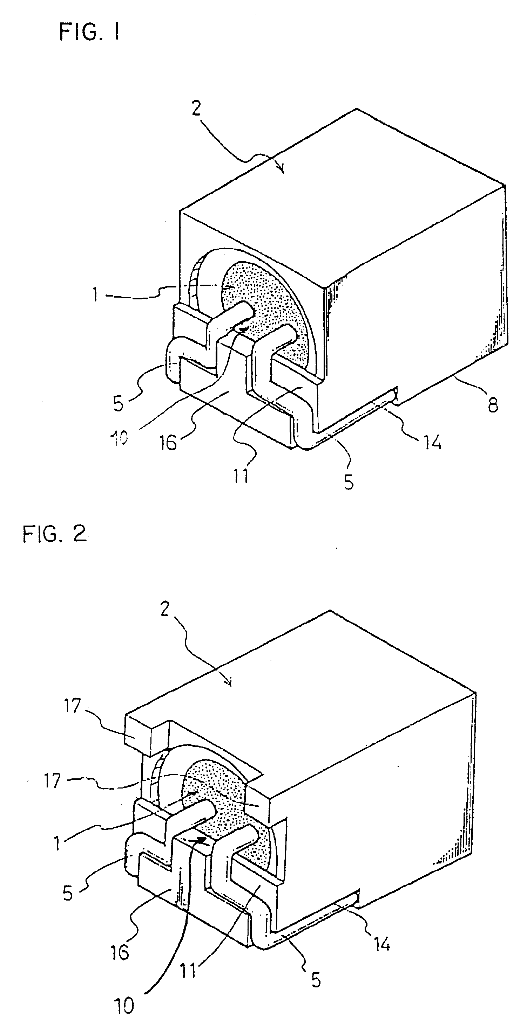

According to Fig. 1, a capacitor 1 is mounted in a sheathing frame 2. Lead wires 5 are derived from the sealing body of the capacitor 1, running through an aperture in the sheathing frame. The lead wires run through an underside 8 of the sheathing frame. A wall section 11 is provided at an aperture of the sheathing frame 2 to cover a part thereof, and a protuberance 16 is arranged in the vicinity almost at the center part of the wall section 11 in the dimension of the height substantially identical to the dimension of the external diameters of the lead wires but higher than these diameters.

In this case, the lead wires 5,5 are so bent alongside the surface of the wall section 11 to detour the protuberance 16 and are further bent alongside the underside 8 of the sheathing frame 2 for accommodation into the groove sections 14,14 provided on the underside 8. As a result, the protuberance 16 and the lead wires 5,5 are arranged in substantially the same plane at the end of the aperture 10 of the sheathing frame 2.

The protuberance 16 is provided in the vicinity of the center portion of the wall section 11, so that a plurality of the lead wires 5,5 led out from the capacitor 1 are separated by each other through the protuberance 16 to prevent a short-circuit accident to be caused by a contact of the lead wires 5,5 to each other.

However, when the ordinary chip type electronic parts are actually mounted on the printed circuit board 7, the electronic parts at its four sides must be held down at the front and the rear, the right and the left by means of a jig to carry out a positioning process for an adjustment of their wiring positions. According to the chip type capacitor of this embodiment, even electronic parts are held down by the jig during positioning process, the protuberance 16 comes into contact with the jig, but never in contact with the jig, ensuring to perform a precise positioning with reduction of the mechanical stress to the capacitor elements due to the jig.

In the embodiment as illutrated in Fig, 2, like the chip type capacitor as shown in Fig. 1, the protuberance 17 is provided in the aperture 10 of the sheathing frame 2 in the dimension of the height identical to the dimension of the height of the protuberance 16 provided in the wall section 11. In this case, the protuberance 16 of the wall section 11 is arranged in the same plane as the protuberance 17 at the aperture 10 of the sheathing frame 2. Accordingly, like the aforementioned embodiment, the stress to be caused by the jig to the lead wires 5,5 may be reduced enabling to wire the lead wires 5,5 while contacting the aperture 10 of the sheathing frame 2 with the printed circuit board 7.

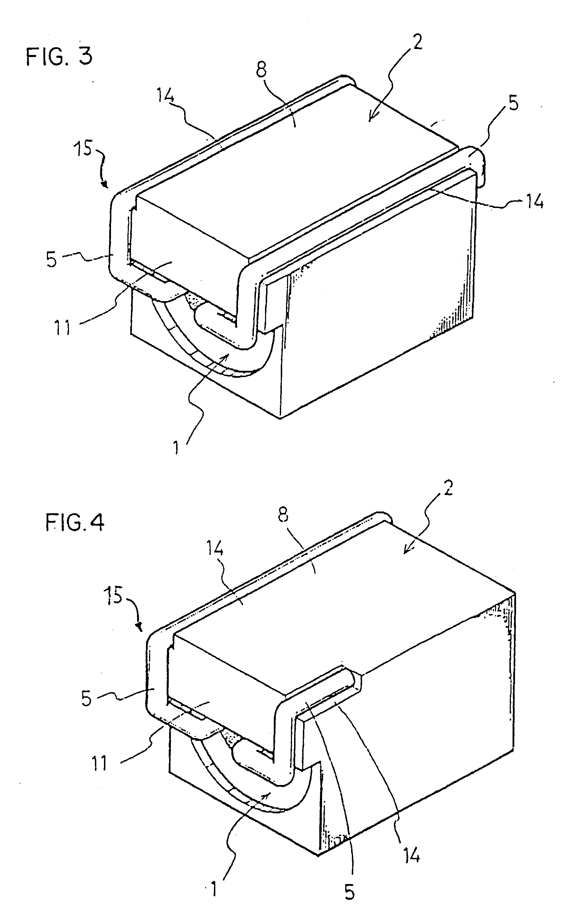

Fig. 3 and 4 illustrate further embodiments of the chip type capacitor according to the invention. In this embodiment, the notched groove sections 14,14 are provided on the edge sections of either sides of the underside 8 of the sheathing frame 2 with a configuration of the same length as the longitudinal dimension of the sheathing frame 2. In this case, the lead wires 5,5 of the capacitor 1 derived from the aperture 10 of the sheathing frame 2 are bent alongside the wall section 11 and the underside 8 of the sheathing frame 2 for accommodation into the slot sections 14,14 and their tips are further bent alongside the end of the opposite side of the wall section 11 to support the sheathing frame 2.

When the chip type capacitor thus arranged is mounted on the printed circuit board 7 by soldering, the work from either end direction of the sheathing frame 2 may be available to conveniently cope with dhe diversified wiring patterns of the printed circuit board 7. Further, when either side of the lead wires 5,5 is soldered at both ends of the sheathing frame 2, a creeping distance between each soldering is prolonged so that a short-circuit accident may be prevented.

Moreover, as shown in Fig. 4, the lengths of the notched groove sections 14,14 provided at the edge sections on both sides of the underside 8 of the sheathing frame 2 may be varied by each other to set the lengths of each lead wire 5,5 corresponding to the lengths of the notched groove section. In this case, an arrangement of the lead wires 5,5 at both ends of the sheathing frame 2 becomes asymmetric, thereby to easily determine a polarity of the capacitor 1.

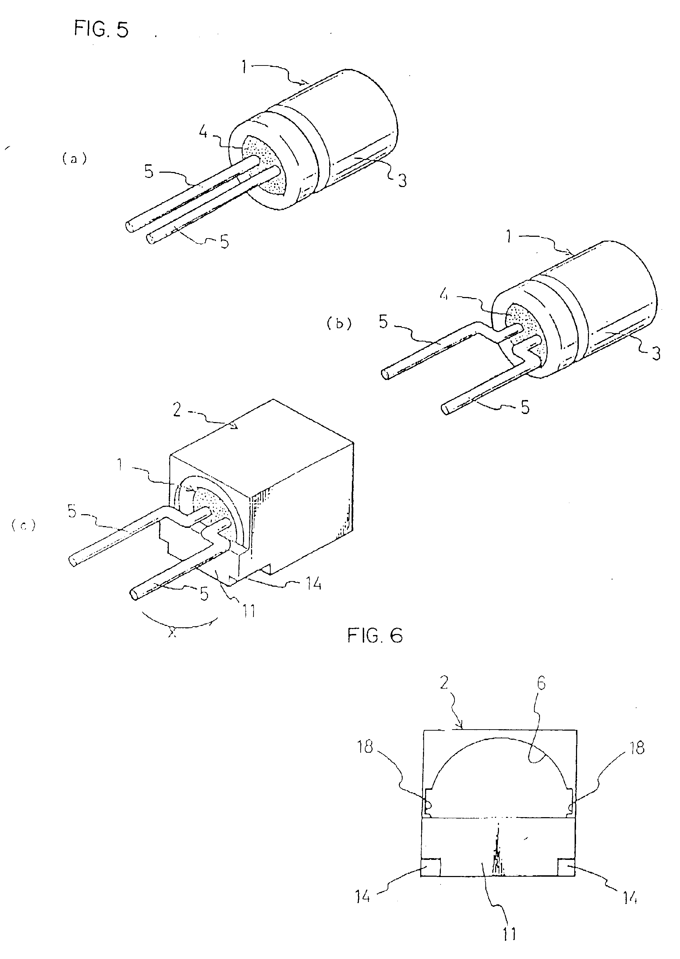

Fig. 5 and 6 illustrate a manufacturing method of the chip type capacitor according to the invention with a proper arrangement of the lead wires for the sheathing frame.

First of all, the lead wires 5,5 of the capacitor 1, before accommodated in the sheathing frame 2, are derived from each other substantially in parallel from the sealing member 4 of the capacitor 1 as shown in Fig. 5. These lead wires 5,5, after being bent in the opposite direction to each other at substantially the right angle in the vicinity of the lead out-section of the sealing member 4 and being separated at a certain constant distance as shown in Fig. 5, are again bent in parallel. This distance should be compatible with the distance of the wiring pattern of the printed circuit board 7 to be mounted. Meanwhile, an ordinary manufacturing method and a bending jig may be applied to the bending process of the lead wires 5,5.

This capacitor 1 is then accommodated as shown in Fig. 5 (c) in the sheathing frame 2 having the accommodation space 6 compatible with the dimension of the external diameter of the capacitor 1 and the notched groove section 14,13 provided on the underside 8. Further, with the capacitor 1 being accommodated in the sheathing frame 2, the lead wires 5,5 derived from the aperture 10 of the sheathing frame 2 are bent at substantially a right angle to the direction of an arrow mark X alongside the end of the aperture 10 of the sheathing frame 2. The underside 8 and the wires 5,5 are accommodated in the groove sections 14,14.

According to such a manufacturing method of the chip type capacitor, the pitch between the lead wires 5,5 is determined by an ordinary lead wire bending process, before accommodating the capacitor 1 into the sheathing frame 2. Accordingly, after accommodating the capacitor 1 into the sheathing frame 2, it may secure a proper separating distance by merely orientating the lead wires 5,5 to the underside 8 and bending them at substantially the right angle.

Meanwhile, this embodiment has described the case in which the lead wires 5,5 are accommodated in the groove sections 14,14 provided in the underside 8 of the sheathing frame 2 but, as mentioned before, the distance of the lead wires 5,5 is determined before accommodating the lead wire into the sheathing frame 2 free of the groove sections 14,14, nevertheless an accommodation of the lead wires 5,5 into the groove sections 14,14 is extremely effective to secure their stability at the underside 8 of the sheathing frame 2.

Further in this embodiment, the lead wires 5,5 are at a distance to each other at the pitch shorter than the dimension of the external diameter of the capacitor 1, so that they may be distanced at the longer pitch. In this case, the lead wires 5,5 are slightly bent in the direction to the center section at the lead-out section from the sealing member 4, and the distance between the lead wires 5,5 is momentarily formed shorter than the dimension of the internal diameter of the accommodating space 6 of the sheathing frame 2 and then, after accommodating the capacitor 1 into the sheathing frame 2, the distance between the lead wires 5,5 is restored to the original condition.

As a manufacturing method according to the invention, the sheathing frame 2 configurated as shown in Fig. 6 may be used. Namely, in the sheathing frame 2 as shown in Fig. 6, the lead wire inserting grooves 18,18 are provided to position outside from an outer periphery surface of the capacitor 1 at both edge sections of the aperture 10. When the sheathing frame 2 is used, the lead wires 5,5 derived from the capacitor 1 are distanced in advance longer than the dimension of the external diameter of the capacitor 1 and then, when the capacitor 1 is accommodated into the sheathing frame 2, the lead wires 5,5 are inserted into the lead wire inserting grooves 18,18. Then, the lead wires 5,5 led out from the end of the aperture 10 of the sheathing frame 2 are bent alongside their ends and the underside 8.

Even though the distance between the lead wires 5,5 is more enlarged than the dimension of the external diameter of the capacitor 1, the capacitor 1 may conveniently be accommodated into the sheathing frame 2.

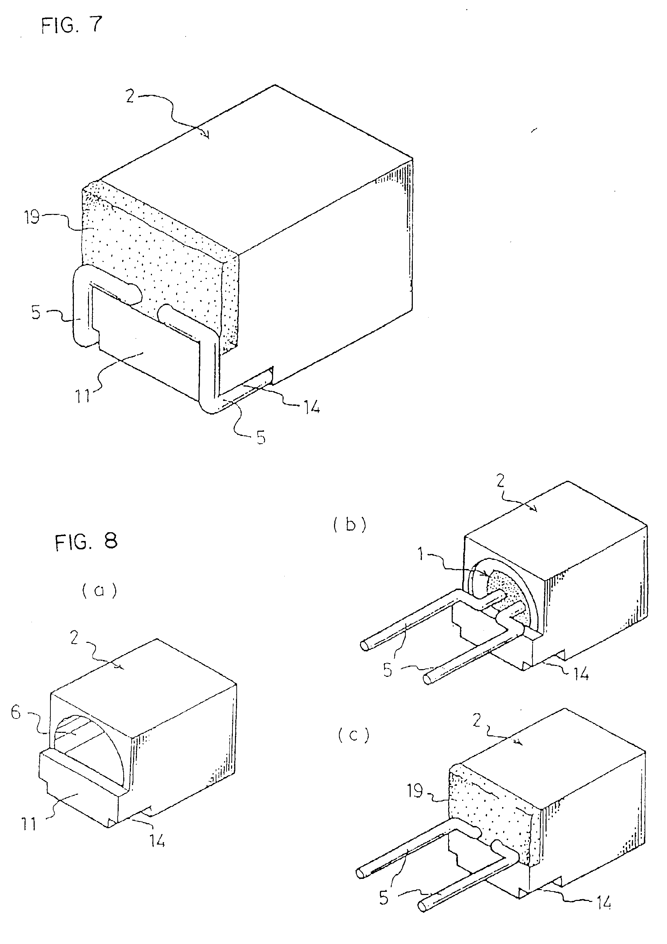

Fig. 7 and 8 illustrate further embodiments of providing a resin layer for sealing the aperture and manufacturing thereof. Fig. 7 illustrates the chip type capacitor according to the embodiment. Namely, in this embodiment a resin layer 19 is provided to cover the aperture 10 of the sheathing frame 2 in which the capacitor 1 is accommodated. It may be sufficient enough for the resin layer 19 to cover at least a part of the sealing member 4 from which the lead wires 5,5 of the capacitor 1 are extended. Also, as a means of forming the resin layer 19, any means may be used, for example, it may be formed by coating a molten synthetic resin material over an essential part with solidification.

Next, the manufacturing method of the chip type capacitor thus configurated is further described with reference to Fig. 8. At first, the capacitor 1 with the lead wires 5,5 bent and processed as shown in Fig. 5 (a) and (b) are accommodated into the sheathing frame 2 configurated as shown in Fig. 8 (a) and (b). Then a molten synthetic resin material, for example, a thermosetting synthetic resin material of an excellent heat resistance is applied to cover the end of the aperture 10 of the sheathing frame 2 for subsequent solidification thereby to obtain a resin layer 19 (Fig. 8 (c)). The lead wires 5,5 protruded from the resin layer 19 are bent alongside from the end of said resin layer 19 to the surface of the wall section 11 of the sheathing frame 2 and the underside 8 for accommodation into the groove sections 14,14 provided on the underside 8 of the sheathing frame 2 to obtain the chip type capacitor having the resin layer 19 thus formed on the aperture 10 of the sheathing frame 2.

The lead wires 5,5 are bent after the resin layer 19 has been formed on the aperture 10 of the sheathing frame 2. Accordingly, the stress to be caused by bending the lead wires 5,5 does not directly influence the body of the capacitor 1 inside the sheathing frame 2 but is rather reduced with improved reliability.

Furthermore, when the resin layer 19 entirely covers the aperture 10 of the sheathing frame 2, the thermal stress to the body of the capacitor 1 is reduced. Meanwhile, the chip type capacitor having the capacitor accommodated in the conventional closed-end cylindrical sheathing frame has such a disadvantage that impurities such as detergents and the like are intermixed through the inserting holes of the lead wires for penetration through the sealing member of the capacitor with corrosion of the capacitor elements. According to the chip type capacitor of the present invention, however, at least the lead-out section of the lead wires 5,5 is covered with the resin layer 19 so that the penetration of detergents such as Freon® and the like is prevented for effective escape from corrosion.

As is obvious from the aforementioned embodiments, according to the invention, a chip type capacitor most suitable for mounting on the surface of the printed circuit board may be obtained at a reduced cost without providing any substantial change in the structure per se of an ordinary capacitor.

Further, by providing the wall section in the aperture of the sheathing frame to cover a part thereof, the capacitor is positioned and fixed in the accommodating space of the sheathing frame eliminating the work of inserting lead wires through the through-holes provided in the closed-end section of the sheathing frame like the conventional one free of any sophisticated processing accuracy to manufacture a chip type capacitor with a convenient step and at a low cost.

## Claims

1. A chip type capacitor assembly, comprising a capacitor (1) having lead wires (5) derived from a terminal side thereof and a sheathing frame (2) having an underside (8) and defining an accommodating space (6) complemantary with an external shape of the capacitor (1) wherein the lead wires (5) of the capacitor (1) accommodated in the sheathing frame (2) are bent alongside of the sheathing frame (2) to the underside (8) of the sheathing frame (2), wherein an end face of the sheathing frame (2) is provided with an aperture (10) for leading out the lead wires (5) the aperture (10) being partly covered with a wall section (11) and notched groove sections (14) for receiving the lead wires (5) are provided on the underside (8) of the sheathing frame (2),
characterized in that
a protuberance (16) of a height higher than the external diameter of the lead wires (5) of the capacitor (1) is arranged on the wall section (11), and the lead wires (5) led out from the end of the aperture (10) of the sheathing frame (2) are bent alongside the surface of the wall section (11) to the underside (8), thereby being bent along the protuberance (16) and are received in the notched groove sections (14), whereby the overall area of the underside face of the sheathing frame (2) permits direct mounting to a printed circuit board.

2. A chip type capacitor according to claim 1, characterized in that slot sections (15) are arranged on the wall section (11) which is provided at an end of the aperture (10) on one side of the sheathing frame (2) for covering a part thereof over which slot sections (15) the lead wires (5) of the capacitor are bent to accommodate lead wires.

3. A chip type capacitor according to claim 1 or 2, characterized in that a protuberance (9) of a height substantially identical to the height of the protuberance (16) arranged on the wall section (11) is formed.

4. A chip type capacitor according to claim 1, characterized in that the lead wires (5) of the capacitor (1) accommodated in the sheathing frame (2) are bent alongside from one end of the aperture (10) of the sheathing frame (2) to the underside (8) thereof and also at least one lead wire (5) on one side is led to an end opposed to the leading side of the lead wires (5) of the sheathing frame (2).

5. A chip type capacitor according to claim 1, characterized in that resin layer is arranged on one side of the aperture (10) of the sheathing frame (2) from which lead wires (5) of the capacitor (1) accommodated in the sheathing frame (2) are led out to cover at least a lead-out section of the lead wires (5) from the capacitor sealing body (3,4).

6. A chip type capacitor according to one of the preceding claims, characterized in that the lead wires (5) are preformed to dimensions larger than the external shape of the capacitor (1) being bent in the vicinity of a lead-out section of the lead wires (5) deriving from the aperture (10) of the sheathing frame (2), and are tacked to dimensions below the internal diameter of the accommodating space of the sheathing frame (2), and that the capacitor (1) is accommodated in the sheathing frame (2) before the lead wires (5) are again bent at the lead-out section for restoration to the desired dimensions.

7. A chip type capacitor according to one of the preceding claims, characterized in that the capacitor (1) being accommodated in the sheathing frame (2) is provided with a resin layer in one side of the aperture of the sheathing frame (2) from wich the lead wires (5) of the capacitor (1) are derived, said resin layer covering at least a lead-out section of the lead wires from the capacitor sealing body (3,4), before the lead wires (5) are bent alongside from the end of the aperture (10) of the sheathing frame (2) to the underside (8) thereof.

## Patentansprüche

1. Kondensatoranordnung der Chip-Art, mit einem Kondensator mit Anschlußdrähten (5), die von einer Anschlußseite desselben abgeleitet sind, und einem Hüllrahmen (2) mit einer Unterseite (8), der einen Aufnahmeraum (6) komplementär zu einer äußeren Form des Kondensators (1) festlegt, wobei die Anschlußdrähte (5) des Kondensators (1), der in dem Hüllrahmen (2) aufgenommen ist, entlang dem Hüllrahmen (2) zu der Unterseite (8) des Hüllrahmens (2) gebogen sind, wobei eine Endseite des Hüllrahmens (2) zum Herausführen der Anschlußdrähte (5) mit einer Öffnung (10) versehen ist, wobei die Öffnung (10) teilweise mit einem Wandabschnitt (11) abgedeckt ist, und eingekerbte Nutenabschnitte (14) für die Aufnahme der Anschlußdrähte (5) auf der Unterseite (8) des Hüllrahmens vorgesehen sind, dadurch **gekennzeichnet,** daß ein Vorsprung (16) einer Höhe, die höher als der äußere Durchmesser der Anschlußdrähte (5) des Kondensators (1) ist, auf dem Wandabschnitt (11) angeordnet ist, und daß die Anschlußdrähte (5), die aus dem Ende der Öffnung (10) des Hüllrahmens (2) herausgeleitet werden, entlang der Oberfläche des Wandabschnitts (11) zur Unterseite (8) gebogen sind, wodurch sie entlang dem Vorsprung (16) gebogen sind, und in den eingekerbten Nutenabschnitten (14) aufgenommen sind, wodurch die gesamte Fläche der Unterseite des Hüllrahmens (2) direkt auf einer gedruckten Leiterplatte oder gedruckten Schaltkreis-Karte angebracht werden kann.

2. Chipkondensator nach Anspruch 1, dadurch gekennzeichnet, daß Schlitzabschnitte (15) auf dem Wandabschnitt (11) angeordnet sind, der an einem Ende der Öffnung (10) auf einer Seite des Hüllrahmens (2) zum Abdecken eines Teils derselben vorgesehen ist, wobei zur Aufnahme der Anschlußdrähte die Anschlußdrähte (5) des Kondensators über diese Schlitzabschnitte (15) gebogen sind.

3. Chipkondensator nach Anspruch 1 oder 2, dadurch gekennzeichnet, daß ein Vorsprung (9) einer Höhe, die im wesentlichen gleich der Höhe des Vorsprungs (16) ist, der auf dem Wandabschnitt (11) angeordnet ist, gebildet wird.

4. Chipkondensator nach Anspruch 1, dadurch gekennzeichnet, daß die Anschlußdrähte (5) des Kondensators (1), der in dem Hüllrahmen (2) aufgenommen ist, entlang eines Endes der Öffnung (10) des Hüllrahmens (2) zur Unterseite (8) desselben gebogen sind, und daß auch mindestens ein Anschlußdraht (5) auf einer Seite zu einem Ende geleitet wird, das der Anschlußseite der Anschlußdrähte (5) des Hüllrahmens gegenüberliegt.

5. Chipkondensator nach Anspruch 1, dadurch gekennzeichnet, daß eine Harzschicht auf einer Seite der Öffnung (10) des Hüllrahmens (2) angeordnet ist, von der die Anschlußdrähte (5) des Kondensators (1), der in dem Hüllrahmen (2) aufgenommen ist, herausgeleitet werden, um mindestens einen Herausleit-Abschnitts der Anschlußdrähte (5) aus dem Kondensator-Abdichtkörper (3, 4) abzudecken.

6. Chipkondensator nach einem der vorhergehenden Ansprüche, dadurch gekennzeichnet, daß die Anschlußdrähte (5) mit Abmessungen vorgeformt sind, die größer sind als die äußere Form des Kondensators (1), wobei sie in der Nähe eines Herausleit-Abschnitts der Anschlußdrähte (5) gebogen werden, die von der Öffnung (10) des Hüllrahmens (2) herausgeleitet werden, und auf Abmessungen unterhalb des inneren Durchmessers des Aufnahmeraums des Hüllrahmens (2) gebracht werden, und daß der Kondensator (1) im Hüllrahmen (2) aufgenommen wird, bevor die Anschlußdrähte (5) wieder am Herausleit-Abschnitt zur Wiederherstellung der gewünschten Abmessungen gebogen werden.

7. Chipkondensator nach einem der vorhergehenden Ansprüche, dadurch gekennzeichnet, daß der Kondensator (1), der in dem Hüllrahmen (2) aufgenommen ist, in einer Seite der Öffnung des Hüllrahmens (2) mit einer Harzschicht versehen ist, von welcher Seite die Anschlußdrähte (5) des Kondensators (1) herausgeleitet werden, wobei die Harzschicht mindestens einen Herausleit-Abschnitt der Anschlußdrähte aus dem Kondensator-Abdichtkörper (3, 4) abdeckt, bevor die Anschlußdrähte (5) entlang dem Ende der Öffnung (10) des Hüllrahmens (2) zur Unterseite (8) desselben gebogen werden.

## Revendications

1. Assemblage de condensateur de type puce, comprenant un condensateur (1) comportant des fils de plomb (5) branchés à partir d'un côté de bornes du condensateur et une armature d'enveloppe (2) ayant un côté inférieur (8) et définissant un espace de logement (6) complémentaire d'une forme externe du condensateur (1) dans lequel les fils de plomb (5) du condensateur (1) disposés dans l'armature d'enveloppe (2) sont recourbés le long de l'armature d'enveloppe (2) vers le côté inférieur (8) de l'armature d'enveloppe (2), une face d'extrémité de l'armature d'enveloppe (2) étant pourvue d'une ouverture (10) pour amener vers l'extérieur les fils de plomb (5), l'ouverture (10) étant partiellement couverte par une partie de paroi (11) et des parties de rainures (14) entaillées pour recevoir les fils de plomb (5) étant prévues sur le côté inférieur (8) de l'armature d'enveloppe (2), caractérisé
en ce qu'une protubérance (16) d'une hauteur supérieure au diamètre externe des fils de plomb (5) du condensateur (1) est aménagée sur la partie de paroi (11), et
les fils de plomb (5) amenés à l'extérieur à partir de l'extrémité de l'ouverture (10) de l'armature d'enveloppe (2) sont recourbés le long de la surface de la partie de paroi (11) vers le côté inférieur (8), étant ainsi recourbés le long de la protubérance (16), et sont reçus dans les parties de rainures entaillées (14), de sorte que toute la surface de la face du côté inférieur de l'armature d'enveloppe (2) permet le montage direct sur une planche de circuit imprimé.

2. Condensateur de type puce selon la revendication 1, caractérisé en ce que des parties de fentes (15) sont disposées sur la partie de paroi (11) qui est prévue à une extrémité de l'ouverture (10) sur un côté de l'armature d'enveloppe (2) pour en couvrir une partie, les fils de plomb (5) du condensateur étant recourbés par dessus lesdites parties de fentes (15) pour recevoir les fils de plomb.

3. Condensateur de type puce selon la revendication 1 ou 2, caractérisé en ce qu'une protubérance (9) d'une hauteur pratiquement identique à la hauteur de la protubérance (16) aménagée sur la partie de paroi (11) est formée.

4. Condensateur de type puce selon la revendication 1, caractérisé en ce que les fils de plomb (5) du condensateur (1) disposé dans l'armature d'enveloppe (2) sont recourbés à partir d'une extrémité de l'ouverture (10) de l'armature d'enveloppe (2) vers le côté inférieur (8) de celle-ci et également au moins un fil de plomb (5) d'un côté est amené vers une extrémité opposée au côté avant des fils de plomb (5) de l'armature d'enveloppe (2).

5. Condensateur de type puce selon la revendication 1, caractérisé en ce qu'une couche de résine est disposée sur un côté de l'ouverture (10) de l'armature d'enveloppe (2) à partir duquel des fils de plomb (5) du condensateur (1) disposé dans l'armature d'enveloppe (2) sont amenés vers l'extérieur pour couvrir au moins une zone de sortie des fils de plomb (5) par rapport au corps d'étancheité (3,4) du condensateur.

6. Condensateur de type puce selon l'une des revendications précédentes, caractérisé en ce que les fils de plomb (5) sont préformés à des dimensions supérieures au contour externe du condensateur (1), recourbés au voisinage d'une zone de sortie des fils de plomb (5) branchés à partir de l'ouverture (10) de l'armature d'enveloppe (2), et sont soudés à des dimensions inférieures au diamètre interne de l'espace de logement de l'armature d'enveloppe (2), et en ce que le condensateur (1) est placé dans l'armature d'enveloppe (2) avant que les fils de plomb (5) soient à nouveau recourbés au niveau de la zone de sortie, pour un retour aux dimensions souhaitées.

7. Condensateur de type puce selon l'une des revendications précédentes, caractérisé en ce que le condensateur (1) étant disposé dans l'armature d'enveloppe (2), il est pourvu d'une couche de résine d'un côté de l'ouverture de l'armature d'enveloppe (2) à partir duquel les fils de plomb (5) du condensateur (1) sont branchés, ladite couche de résine couvrant au moins une zone de sortie des fils de plomb à partir du corps d'étanchéité (3,4) du condensateur, avant que les fils de plomb (5) ne soient recourbés le long de l'armature d'enveloppe à partir de l'extrémité de l'ouverture (10) de l'armature d'enveloppe (2) vers son côté inférieur (8).
